**Europäisches Patentamt**

**European Patent Office**

**Office européen des brevets**

(19)

(11) Publication number: **0 129 291**

**B1**

(12) **EUROPEAN PATENT SPECIFICATION**

(45) Date of publication of patent specification: **09.09.87**

(21) Application number: **84200850.0**

(22) Date of filing: **13.06.84**

(51) Int. Cl.⁴: **C 03 B 37/025,** C 23 C 16/04, C 03 C 17/02

(54) Method of and device for manufacturing optical fibres.

(30) Priority: **15.06.83 NL 8302127**

(43) Date of publication of application:
**27.12.84 Bulletin 84/52**

(45) Publication of the grant of the patent:
**09.09.87 Bulletin 87/37**

(84) Designated Contracting States:
**AT BE CH DE FR GB IT LI NL SE**

(56) References cited:
**DE-A-2 930 781**
**GB-A-2 079 742**
**US-E- 30 635**

(73) Proprietor: **N.V. Philips' Gloeilampenfabrieken**
**Groenewoudseweg 1**
**NL-5621 BA Eindhoven (NL)**

(72) Inventor: **van Geelen, Andreas Nicolaas**
**c/o INT. OCTROOIBUREAU B.V. Prof. Holstlaan 6**
**NL-5656 AA Eindhoven (NL)**
Inventor: **Peelen, Jan Gerard Jacob**
**c/o INT. OCTROOIBUREAU B.V. Prof. Holstlaan 6**
**NL-5656 AA Eindhoven (NL)**
Inventor: **Venhuizen, Hendrik**
**c/o INT. OCTROOIBUREAU B.V. Prof. Holstlaan 6**
**NL-5656 AA Eindhoven (NL)**

(74) Representative: **Auwerda, Cornelis Petrus et al**
**INTERNATIONAAL OCTROOIBUREAU B.V. Prof.**
**Holstlaan 6**
**NL-5656 AA Eindhoven (NL)**

EP 0 129 291 B1

Courier Press, Leamington Spa, England.

## Description

The invention relates to a method of manufacturing optical fibres in which glass layers are deposited on the inside of a glass tube which is heated at a temperature between 1100 and 1300°C by passing a reactive gas mixture through the tube at a pressure between 0.13 and 13.33 kPa and reciprocating a plasma in the interior of the tube; after a sufficient number of glass layers have been deposited, the tube is collapsed to form a solid preform and the preform is drawn into an optical fibre. Glass is to be understood to mean in this connection also synthetic glass and amorphous quartz obtained from quartz crystals by fusion (fused silica, quartz glass), doped or undoped.

The manufacture of optical fibres by means of this method is disclosed inter alia in United States Patent Specification RE 30635 and 4,314,833. In the art said method is known as the "non-isothermal plasma CVD-process (non-isothermal PCVD). In this method, glass layers are deposited directly from the gaseous phase onto the inner wall of the glass tube (heterogeneous reaction). The formation of glass soot in the gaseous phase is avoided (see in this connection in particular the above-mentioned United States Patent Specification 4,314,833). In principle it is not necessary in this method to rotate the glass tube so as to ensure a rotationally symmetrical deposition. In practice the diffusion in the gaseous phase of charged particles formed in the plasma (ions, excited atoms and the like) to the glass wall does not seem to be biased by gravity. This is in contrast with a so-called homogeneous deposition process in which glass particles are formed in the gaseous phase: in this case the deposition of said glass particles is biased by gravity. In methods in which glass particles are formed in the gaseous phase and are deposited on the interior of a tube, the tube is rotated continuously at a rather high speed so as to ensure a rotationally symmetrical deposition (see for example United States Patent Specification 4,217,027, which describes the MCVD-process: the speed of rotation is 100 rpm). The gas pressure in these deposition processes usually is equal to or larger than atmospheric pressure and therefore no particularly high requirements need be imposed upon the rotation couplings with respect to their gas-tightness.

In an industrial production of optical fibres according to the PCVD-process it sometimes appears that a rotationally asymmetric deposition of the glass layers can nevertheless occur. This is detrimental because a rotationally asymmetric deposition of the glass layers may lead to a reduction of the expected bandwidth. The rotationally asymmetric deposition has been found to have various causes, which each individually or in combination can detrimentally influence the optical properties of the manufactured optical fibre. If during the movement of the resonant cavity for generating the plasma, the glass tube is not in the centre of the resonant cavity throughout its length, a rotationally asymmetric distribution of the plasma will occur in the tube. The glass tube may have imperfections which may also result in a non-uniform deposition of the glass layers. These imperfections may consist in that the tube is not completely straight and/or does not have the same outside and/or inside diameter throughout its length. Furthermore, imperfections in the furnace may lead to a non-uniform heating.

Preventing or reducing the disadvantages of a rotationally asymmetric deposition of the glass layers by continuous rotation of the glass tube during the deposition as used, for example, in the above-mentioned MCVD-process, meets with a number of disadvantages in the present PCVD-process, which are related to the difference in performing the process.

The MCVD-process is usually carried out above or at about atmospheric pressure. Leakage in the rotation coupling used does not result in the ambient atmosphere leaking into the glass tube. The PCVD-process is carried out at a sub-atmospheric pressure. If the rotation coupling is not completely sealed from the atmosphere, the ambient atmosphere is drawn into the tube with all the resulting detrimental disadvantages, for example, increase of the attenuation by incorporation of water in the glass layers which are formed in the tube. Detrition products originating from the rotating parts of the coupling can also be drawn into the tube and can also detrimentally influence the properties of the optical fibre. An adequate sealing which can be used continuously without the described disadvantages occurring is difficult to realize in practice. The consideration should be taken into account that already extremely small quantities of impurities (in the order of 0.1 ppm) may give rise to a noticeable increase of the attenuation (in the order of 1 db/km) in the optical fibre.

It is the object of the invention to reduce the rejects in optical fibres manufactured on a factory scale in the non-isothermal PCVD-process and to ensure a uniform good optical quality as far as possible.

According to the invention this object is achieved by means of a method which is characterized in that the glass tube is hermetically connected to a gas supply system and to a vacuum pump via flexible tubing, during the deposition of the glass layers the glass tube is rotated stepwise through an angle equal to $360°/n$, each time the direction of movement of the plasma in the tube is reversed, where $n$ is an integer larger than or equal to 2, until the tube has been rotated through at least 360°, after which the direction of rotation is reversed, all this being repeated until all the glass layers have been deposited.

In practice it has been found that a considerable improvement of the optical properties can be obtained already at comparatively small values of $n$ by means of the stepwise rotation according to the invention, in particular the bandwidth is significantly favourably influenced. If an asymmetric deposition pattern would occur in a stationary tube, in the method according to the invention the asymmetric deposition pattern would be symmetrically distributed over the circumference of the tube over a number of successive layers. During the heating at higher temperature following the deposition in order to contract and collapse the tube so as to form a solid preform and during drawing the fibre therefrom, a further equalisation of the deposition pattern is produced by diffusion between the layers.

Suitable values of $n$ are equal to an integer from 2 to 12, preferably 4 to 10.

The flexible tubing may consist, for example, of a reinforced hose of a synthetic resin which can be reeled and which can withstand the gas mixture which is passed through the tube at the operating temperature. Flexible hoses (bellows) of stainless steel, for example a Cr-Ni-Fe steel, which is not chemically attacked by the gas mixture are preferably used.

The invention also relates to a device for carrying out the method. This device for providing glass layers on the inside of a glass tube comprises a gas supply device which is connected to one end of the glass tube, a furnace for heating the glass tube, a resonant cavity for generating a plasma in the glass tube, and means to reciprocate the resonant cavity along the glass tube, a high frequency generator which is connected to the resonant cavity and a vacuum pump which is connected to the other end of the glass tube. The device is characterized in that the means for connecting the gas supply device to the glass tube and the means connecting the vacuum pump to the glass tube consist of flexible tubing and hermetically connect the gas supply device and the vacuum pump respectively to the glass tube and in that means are present which, each time the direction of movement of the resonant cavity along the tube is reversed, rotate the glass tube in a stepwise manner through a previously determined angle.

In an embodiment which has proved suitable in practice the means for rotating through a previously adjusted angle consist of an electronic control unit or a stepping motor which is coupled to a rotatable shaft which is arranged parallel to the tube and on which two discs are present which transmit a movement of the shaft to the glass tube *via* endless chains or belts *via* discs coupled to the glass tube. The stepping motor is actuated *via* a control device which switches on the motor when the resonant cavity is in the reversal points of its movement. All this can be established and controlled by electronic, optical or mechanical transducers.

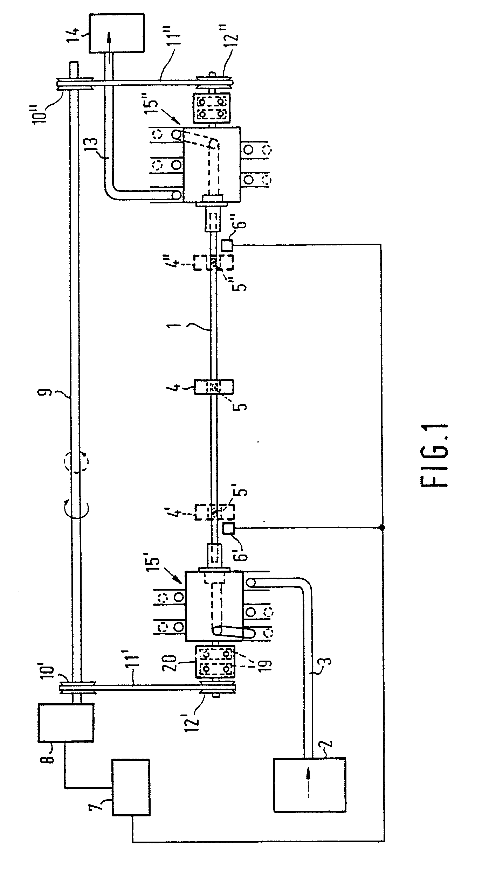

The invention will now be described in greater detail with reference to the accompanying drawings. Fig. 1 in the drawing diagrammatically shows the essential parts of a device according to the invention.

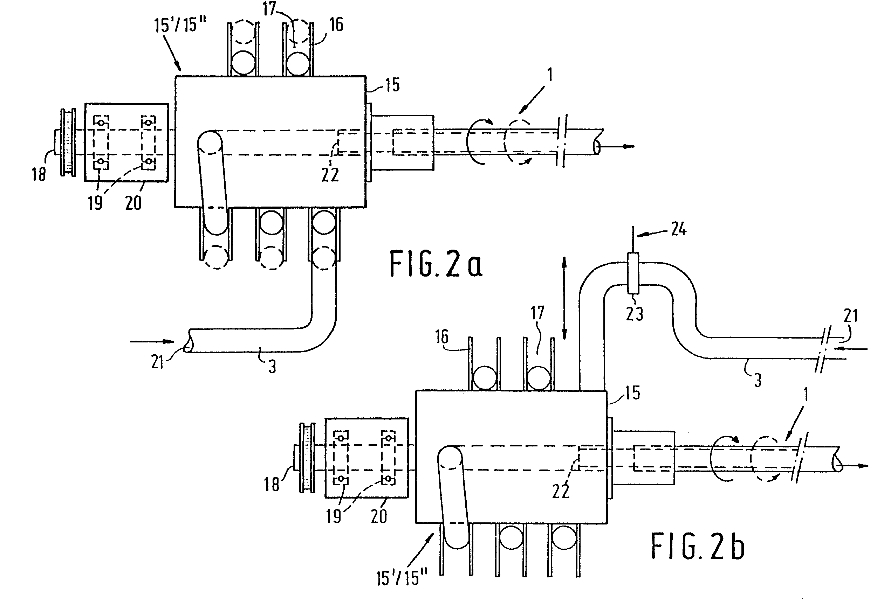

Figs. 2a, 2b show diagrammatically and in greater detail bellows guide means.

A gas mixture is passed through a tube 1 of quartz glass (fused silica) from a gas supply device 2, connected hermetically to the tube 1 *via* a flexible tube 3. The gas mixture has such a composition that it forms glass layers on the wall of the glass tube under the influence of a non-isothermal plasma. It may consist, for example, of a mixture of silicon tetrachloride ($SiCl_4$) and oxygen, the mixture may further comprise a dopant in a constant or varying quantity, for example, a volatile hydrogen-free fluorine compound and/or germanium tetrachloride. The flexible tube 3 may consist, for example, of bellows of stainless steel having a wall thickness of 0.1 mm. A resonant cavity 4 for generating the non-isothermal plasma 5 in the tube 1 is reciprocated past the tube 1 (movement means not shown). The resonant cavity is connected to a highfrequency generator (not shown). The extreme positions of the resonant cavity 4 and the plasma 5 are denoted by 4', 5' and 4'', 5'', respectively. When the position 4' or 4'' is reached, a signal is transmitted *via* an electric or mechanical transducer 6' or 6'' to a control device 7 which is connected to a stepping motor 8. The stepping motor 8 actuates a rod 9 on which two chain wheels 10' and 10'' are present which *via* chains 11' and 11'', drive two chain wheels 12' and 12'', which are provided on the shaft of the bellows guide means 15' and 15''.

Each time when the resonant cavity 4 is in either of the extreme positions 4' and 4'', a signal is transmitted to the control device 7. The control device 7 in turn switches on the stepping motor when a signal from one of the transducers 6' and 6'' is received. The stepping motor 8 rotates the rod 9 through a previously adjusted angle $360°/n$ as a result of which the tube 1 is also rotated through said angle. The tube 1 is hermetically connected to a vacuum pump 14 *via* a flexible tube 13. Tube 13 consists of the same material as tube 3. At the onset of the deposition of the glass layers of the inside of the tube 1 between the extreme positions 4' and 4'' of the resonant cavity 4, the tubes 3 and 13 are reeled on bellows guide means 15' and 15'', respectively. During the deposition process a furnace which heats the tube 1 at a temperature between 1100 and 1300°C is present around the tube 1. Said furnace as well as the above-mentioned high-voltage generator and the movement means for the resonant cavity are not shown in Fig. 1 to avoid complexity of the drawing. Each time when the stepping motor 8 is switched on by the control device 7 and the tube 1 rotated through an angle $360°/n$ in a first direction, the radius of curvature of the turns of the tubes 3 and 13 on the bellows guide means 15' and 15'' is increased. The control device 7 is adjusted so that the direction of rotation of the stepping motor 8 is reversed after the stepping motor has been switched on at least $n$ times. The radius of curvature of the turns of the tubes 3 and 13 on the bellows guide means 15' and 15'' then decreases.

Fig. 2a shows diagrammatically the flexible hose guide means 15' and 15'', respectively, used in the device shown in Fig. 1 for reeling and unreeling a flexible tube 3 (like reference numerals have the same meanings as in Fig. 1, for 3 may also be read 13).

The device comprises a cylinder 15. Present on said cylinder 15 is an upright edge 16 which bounds a helical groove 17. A flexible tube 3, for example, stainless steel bellows is reeled in the groove 17. One possible extreme position is shown in Fig. 2a in solid lined. The tubing 3 is at the circumference of the cylindrical member 15. The other extreme position is shown in broken lines. This position is achieved after the cylinder has been rotated stepwise in that sense that the tube 3 is unreeled from the cylinder 15 and the turns obtain a larger radius of curvature. Cylinder 15 may be rotated by means of a shaft 18 which may be connected to an electrical control unit or a stepping motor. The shaft 18 is journalled (bearing 19) in a housing 20. The upright edge 16 is so high that the tube 3 cannot accidentally get out of the grooves 17. Ends 21 and 22 of the tube 3 are hermetically connected to a gas supply device 2 and the glass tube 1 (Fig. 1). If the tube 3 (in that case tube 13, Fig. 1) serves to exhaust gases from the tube 1, the part 21 of the tube is connected to a vacuum pump 14.

Fig. 2b shows diagrammatically another embodiment of bellows guide means 15' and 15'', respectively (like reference numerals have the same meanings as in the preceding figures 1 and 2a). Each time when the shaft 18 is rotated, a part of the flexible tube 3 is unreeled from the bellows guide means 15'. *Via* the noose 23 which is connected to a counterweight (not shown) *via* a wire 24 extending over a guide wheel (not shown), the flexible tube 3 is pulled aside during unreeling. When the bellows guide means 15' is rotated in the opposite sense, the tube 3 is reeled again. When the method and the device according to the invention are used, a uniform quality of the product, optical fibres, is surprisingly ensured in spite of the fact that rotation is not carried out continuously but stepwise. With n=10 up to a doubling of the bandwidth of the optical fibres was obtained by means of the method according to the invention.

## Claims

1. A method of manufacturing optical fibres in which glass layers are deposited on the inside of a glass tube (1) heated at a temperature between 1100 and 1300°C by passing a reactive gas mixture through the tube at a pressure between 0.13 and 13.33 kPa, and reciprocating a plasma (5) in the interior of the tube, the tube, after a sufficient number of glass layers have been deposited, is collapsed to form a solid preform and the preform is drawn into an optical fibre, characterized in that the glass tube (1) is hermetically connected via flexible tubing (3, 13) to a gas supply system (2) and to a vacuum pump (14), and the glass tube during deposition of the glass layers is rotated through an angle equal to 360°C/n, where n is an integer larger than or equal to 2, each time when the direction of movement of the plasma (5) in the tube is reversed, until the tube has been rotated through at least 360°, after which the direction of rotation is reversed, all this being repeated until all the glass layers have been deposited.

2. A method as claimed in Claim 1, characterized in that n is equal to an integer from 2 to 12.

3. A method as claimed in Claim 2, characterized in that n is equal to an integer from 4 to 10.

4. A device for providing glass layers on the inside of a glass tube (1), comprising a gas supply device (2) which can be connected to one end of the glass tube, a furnace for heating the glass tube, a resonant cavity (4) for generating a plasma (5) in the glass tube, and means to reciprocate the resonant cavity along the glass tube, a highfrequency generator which is connected to the resonant cavity, and a vacuum pump (14) which can be connected to the other end of the glass tube, characterized in that the means for connecting the gas supply device (2) to the glass tube (1) and the means connecting the vacuum pump (14) to the glass tube consist of flexible tubing (3, 13) and hermetically connect the gas device and the vacuum pump respectively to the glass tube and in that means are present which, each time when the movement of the resonant cavity (4) along the tube is reversed, rotate the glass tube in a stepwise manner through a previously determined angle.

## Patentansprüche

1. Verfahren zum Herstellen optischer Fasern, wobei auf der Innenseite eines auf eine Temperatur zwischen 1100 und 1300°C erwärmten Glasrohres (1) Glasschichten dadurch angebracht werden, dass bei einem Druck zwischen 0,13 und 13,33 kPa ein reaktives Gasgemisch durch das Rohr hindurchgeführt und in dem Innern des Rohrs ein Plasma (5) hin- und herbewegt wird, wobei daraufhin das Rohr, nachdem eine ausreichende Anzahl Glasschichten angebracht sind zu einer massiven Vorform kollabiert und die Vorform zu einer optischen Faser ausgezogen wird, dadurch gekennzeichnet, dass das Glasrohr (1) über biegsame Leitungen (3, 13) mit einem Gasversorgungssystem (2) und mit einer Vakuumpumpe (14) hermetisch verbunden wird und das Glasrohr beim Anbringen der Glasschichten jeweils wenn die Gewegungsrichtung des Plasmas (5) in dem Rohr umgekehrt wird, über einen Winkel gleich 360° gedreht wird, wobei n eine ganze Zahl grösser oder gleich 2 ist, bis das Rohr über mindestens

$$\frac{360°}{n}$$

gedreht ist, wonach die Drehrichtung umgekehrt wird, wobei dies wiederholt wird bis alle alle Glasschichten angebracht sind.

2. Verfahren nach Anspruch 1, dadurch gekennzeichnet, dass n gleich einer ganzen Zahl von 2 bis 12 ist.

3. Verfahren nach Anspruch 2, dadurch gekennzeichnet, dass n gleich einer ganzen Zahl von 4 bis 10 ist.

4. Vorrichtung zum Anbringen von Glasschichten auf der Innenseite eines Glasrohres (1) mit einer Gasversorgungsanlage (2), die mit einem Ende des Glasrohres verbunden werden kann, einem Ofen zum Erwärmen des Glasrohres, eimem Hohlraumresonator (4) zum Erzeugen eines Plasmas (5) in dem Glasrohr und Mitteln um den Hohlraumresonator an dem Glasrohr entlang hin- un herzubewegen, einem HF-Generator, der mit dem Hohlraumresonator verbunden ist und mit einer Vakuumpumpe (14) die mit dem anderen Ende des Glasrohres verbunden werden kann, dadurch gekennzeichnet, dass die Mittel zum Verbinden der Gasversorgungsanlage (2) mit dem Glasrohr (1) und die Mittel, welche die Vakuumpumpe (14) mit dem Glasrohr verbinden aus biegsamen Leitungen (3, 13) bestehen und die Gasversorgungsanlage sowie die Vakuumpumpe hermetisch mit dem Glasrohr verbinden und dass Mittel vorhanden sind, die das Glasrohr jeweils, wenn die Bewegung des Hohlraumresonators (4) an dem Rohr entlang umkehrt, das Glasrohr über einen vorbestimmten Winkel schrittweise drehen.

**Revendications**

1. Procédé pour la réalisation de fibres optiques selon lequel des couches en verre sont déposées sur la face intérieure d'un tube en verre (1) qui est chauffé à une température comprise entre 1100 et 1300°C par passage d'un mélange de gaz réactif par le tube sous une pression comprise entre 0,13 et 13,33 kPa et communication d'un mouvement de va-et-vient à un plasma (5) se trouvant dans le tube, après quoi, après dépôt d'un nombre suffisant de couches en verre, le tube est affaissé pour former une préforme solide et la préforme est étirée en une fibre optique, caractérisé en ce que le tube en verre (1) est relié de façon hermétique à un système d'alimentation de gaz (2) et à une pompe à vide (14) par l'intermédiaire de tuyaux souples (3, 13) et que, lors du dépôt des couches en verre, à chaque fois que la direction de déplacement du plasma (5) dans le tube est inversée, le tube en verre est tourné d'un angle égal à 360°/n, n étant un nombre entier supérieur ou égal à 2, jusqu'à ce que le tube soit tourné d'au moins 360°, après quoi la direction de rotation est inversée, le tout étant répété jusqu'au dépôt de toutes les couches en verre.

2. Procédé selon la revendication 1, caractérisé en ce que n est égal à un nombre entier compris entre 2 et 12.

3. Procédé selon la revendication 2, caractérisé en ce que n est égal à un nombre entier compris entre 4 et 10.

4. Dispositif pour l'application de couches en verre sur la face intérieure d'un tube en verre (1), comportant un dispositif d'alimentation de gaz (2), qui peut être relié à une extrémité du tube en verre, d'un four pour le chauffage du tube en verre, d'une cavité résonante pour la formation de plasma dans le tube en verre, et de moyens pour assurer le mouvement de va-et-vient de la cavité résonante le long du tube en verre, d'un générateur à haute fréquence, qui est relié à la cavité résonante et d'une pompe à vide qui est reliée à l'autre extrémité du tube en verre, caractérisé en ce que les moyens pour relier le dispositif d'alimentation de gaz (2) au tube en verre (1) et les moyens pour relier la pompe à vide au tube en verre sont constitués par un système de tuyaux souples et relient hermétiquement le dispositif d'alimentation de gaz et la pompe à vide respectivement au tube en verre et que des moyens sont présents qui, à chaque fois, que la direction de déplacement de la cavité résonante est inversée le long du tube, assure la rotation du tube en verre d'une façon intermittente d'un angle préalablement déterminé.

FIG.1

0 129 291

FIG.2a

FIG.2b